# EUROPÄISCHE PATENTSCHRIFT

(11) **EP 1 781 835 B1**
(45) Veröffentlichungstag und Bekanntmachung des Hinweises auf die Patenterteilung: **30.04.2014**
(21) Anmeldenummer: 05761583.3
(22) Anmeldetag: 19.07.2005
(51) Int. Cl.: C23C 14/06, C23C 14/34, C23C 16/26

(54) **VERSCHLEISSFESTE BESCHICHTUNG UND VERFAHREN ZUR HERSTELLUNG DERSELBEN**
WEAR-RESISTANT COATING AND METHOD FOR PRODUCING THE SAME
REVETEMENT RESISTANT A L'USURE ET PROCEDE DE REALISATION ASSOCIE

(30) Priorität: 26.08.2004 DE 102004041235
(43) Veröffentlichungstag der Anmeldung: 09.05.2007
(73) Patentinhaber: Schaeffler Technologies GmbH & Co. KG, 91074 Herzogenaurach (DE)
(72) Erfinder: HOSENFELDT, Tim, Matthias, 96106 Ebern (DE); GRELL, Karl-Ludwig, 91086 Aurachtal (DE)
(86) Internationale Anmeldenummer: PCT/EP2005/007829
(87) Internationale Veröffentlichungsnummer: WO 2006/021275

(56) Entgegenhaltungen:
- EP-A- 0 652 301
- EP-A1- 1 338 641
- DE-A1- 19 625 329
- US-A- 4 725 345
- US-A1- 2003 234 176
- US-A1- 2004 074 260
- HOLMBERG K ET AL: "TRIBOLOGICAL CHARACTERISTICS OF HYDROGENATED AND HYDROGEN-FREE DIAMOND-LIKE CARBON COATINGS" DIAMOND FILMS AND TECHNOLOGY, Bd. 4, Nr. 2, Januar 1994 (1994-01), Seiten 113-129, XP000570628 ISSN: 0917-4540

## Beschreibung

### Anwendungsgebiet der Erfindung

Die vorliegende Erfindung bezieht sich auf eine verschleißfeste Beschichtung auf vorbestimmten Flächen von einem reibenden Verschleiß ausgesetzten Maschinenteilen und auf ein Verfahren zur Herstellung einer derartigen verschleißfesten Beschichtung für Maschinenteile in Verbrennungskraftmaschinen.

Nachfolgend werden die vorliegende Erfindung sowie die ihr zugrunde liegende Aufgabe in Bezug auf Maschinenteile für Verbrennungskraftmaschinen, insbesondere in Bezug auf Ventiltriebkomponenten, wie beispielsweise Tassenstößel, näher erläutert.

Es sind Nockenstößelvorrichtungen bekannt, welche in beispielsweise Kraftfahrzeugmotoren mit hin- und hergehenden Kolben eingebaut sind, welche Lufteinlass- und Luftauslassventile aufweisen, die sich in Phase mit der Drehung der Kurbelwelle oder synchron hierzu öffnen und schließen. Ein Ventilantriebsmechanismus wird zur Übertragung der Bewegung des an der Nockenwelle angebrachten Nockens auf die Ventile verwendet, wenn sich die Nockenwelle zusammen mit der Kurbelwelle des Motors dreht. Dabei gelangt der Nocken der Nockenwelle in Reibkontakt mit einer Lauffläche des zugeordneten Tassenstößels.

Allgemein unterliegen moderne Ventiltriebkomponenten, wie beispielsweise derartige Tassen- und Pumpenstößel steigenden Anforderungen bezüglich des Verschleißwiderstandes und der Ressourcenschonung. Die Ursachen für die Notwendigkeit eines erhöhten Verschleißwiderstandes liegen in den immer höher werdenden Belastungen und Beanspruchungen des tribologischen Systems, bestehend aus Steuernocken und -stößel. Die Ursachen hierfür liegen in neuen Motorkonzepten, wie beispielsweise Benzin- und Dieseldirekteinspritzsystemen, mit stetig steigenden Einspritzdrücken, einem zunehmenden Anteil an abrasiven Partikeln im Schmierstoff, mangelnder Ölversorgung der Reibpartner, was einen erhöhten Anteil an Mischreibung zur Folge hat, und der zunehmenden Verwendung von tribologisch ungünstigen Stahlnocken zur Kosten- und Massereduzierung. Ein wichtiger Beitrag zur Ressourcenschonung ist die Reduzierung der Reibungsverluste im Ventiltrieb, mit daraus folgender Kraftstoffeinsparung bei gleichzeitiger Erhöhung der Lebensdauer des gesamten Ventiltriebes. Um die Reibungsverluste effektiv zu reduzieren, ist es notwendig, das Reibmoment im gesamten Drehzahlbereich zu senken, d.h. die Stribeckkurve im Ganzen nach unten zu verschieben.

Es ist bekannt, derartige Tassenstößel als Leichtmetallstößel für die Ventilsteuerung eines Verbrennungsmotors auszubilden, welcher einen Stößelgrundkörper und eine an der Berührungsfläche für die Steuernocken der Ventilsteuerung eingelegte Stahlplatte mit einer gehärteten Oberfläche aufweist.

Nachteilig an diesem Ansatz hat sich jedoch die Tatsache herausgestellt, dass derartige Tassenstößel im Betriebsfall relativ großen Temperaturschwankungen von -30°C bei Kaltstart bis zu ca. 130°C während des Betriebes einer Brennkraftmaschine ausgesetzt sind. Problematisch dabei ist die möglicherweise unterschiedliche Wärmeausdehnung der verwendeten Werkstoffe. Zwar weist die als verschleißfeste Einlage in einen Leichtmetallstößel eingelegte Stahlplatte gute Verschleißeigenschaften auf, jedoch neigt sie bei entsprechender thermischer Belastung zum Ablösen. Die thermische Belastbarkeit ist deshalb begrenzt. Ein weiterer anwendungstechnischer Nachteil besteht darin, dass der Bauraum in Form eines relativ breiten Randes als Funktionsfläche bzw. als Nockenkontaktfläche, die von dem Steuernocken einer Ventilsteuerung kontaktiert wird, verloren geht.

Nach einem Ansatz gemäß dem Stand der Technik ist es ebenfalls bekannt, Laufflächen von auf reibendem Verschleiß ausgesetzten Maschinenteilen mit Verschleißschutzschichten zu versehen, die je nach Anwendungsfall bevorzugt aus galvanisch aufgetragenen Metallen oder aus in einem thermischen Spritzverfahren aufgetragenen Metallen und/oder Metalllegierungen mit gegebenenfalls Hartstoffzusätzen bestehen.

An diesem Ansatz hat sich jedoch die Tatsache als nachteilig herausgestellt, dass thermisch aufgespritzte Metallschichten eine relativ schwache Festigkeit besitzen, und es ist daher bekannt, zur Verbesserung der Festigkeit die Metallschichten nach dem Auftrag durch beispielsweise Plasmastrahlen, Laserstrahlen, Elektronenstrahlen oder durch einen Lichtbogen derart umzuschmelzen, dass sich die Spritzwerkstoffe mit dem dabei gleichzeitig im Obefflächenbereich aufgeschmolzenen Grundwerkstoff schmelzflüssig vermischen und legieren. Beim Umschmelzlegieren entstehen jedoch inhomogene Zonen unterschiedlicher Zusammensetzung, in denen sowohl der Grundwerkstoff als auch das Schichtmaterial überwiegen kann. Bei zu hohem Grundmaterialanteil ist der Schichtverschleiß dann zu hoch, und bei geringem Grundmaterialanteil besteht bei verschiedenen Schichtkombinationen die Gefahr von Makrorissbildungen, sodass solche Schichten nicht einsetzbar sind. In einem derartigen Fall können Reibungsbelastungen einen unerwünschten Adhäsiv-Verschleiß an den Schlichten verursachen.

Ferner ist der Anmelderin der Ansatz bekannt, die Lauffläche des Tassenstößels mittels eines thermochemischen Prozesses zu carbonitrieren und/oder zu nitrocarburieren. An diesem Ansatz hat sich jedoch die Tatsache als nachteilig herausgestellt, dass kein zufriedenstellender Reibungskoeffizient erreicht wird und ein zu geringer Verschleißwiderstand entsteht.

Ferner ist der Anmelderin bekannt, die Lauffläche des Stößels mit einer Manganphosphatschicht oder einem Gleitlack zu beschichten. Auch hierbei werden keine zufriedenstellenden Reibungskoeffizienten und Verschleißwiderstände erreicht. Zudem wird durch derartige Materialien die Umwelt unnötig belastet. Das selbe gilt für galvanische Schichten, die ebenfalls auf den Laufflächen aufgebracht werden können.

Ferner sind im Stand der Technik als Beschichtungsmaterialien Hartmetalle und Schnellarbeitstahle (ASP 23) bekannt, die jedoch neben einem nicht zufriedenstellenden Reibungskoeffizienten und einem nicht zufriedenstellenden Verschleißwiderstand zusätzlich eine nachteilige hohe Masse aufweisen. Ferner ist eine Fertigung derselben lediglich mit einem hohen Fertigungsaufwand verbunden.

Der Anmelderin sind zusätzlich harte, mittels beispielsweise eines PVD- oder eines (PA)CVD-Verfahrens, hergestellte Schichten, wie beispielsweise TiN, CrN, (Ti, Al)N, bekannt. Nachteilig an diesem Ansatz hat sich jedoch die Tatsache herausgestellt, dass diese Schichten einen hohen Verschleiß des Gegenkörpers zur Folge haben.

Aus dem US-Patent 5,237,967 sind kohlenstoffbasierte PVD- und (PA)CVD-Schichten mit 20 bis 60 Atom-% Wasserstoff in der Deckschicht bekannt, sogenannte metallhaltige Kohlenwasserstoffschichten (Me-C:H) und amorphe Kohlenwasserstoffschichten (a-C:H). Diese Schichten weisen jedoch einen zu geringen Verschleißwiderstand und eine geringe chemische Stabilität auf. Ferner besitzen sie einen zu hohen Flüssigkeitsreibungskoeffizienten, da sie keine Reibungsreduzierung im ölgeschmierten Zustand gewährleisten. Aus EP-1338641 sind auch solche Schichten bekannt. US 2004/0074260 offenbart E-modus und Härtewerte für Ta-C-Schichten.

Somit liegt der vorliegenden Erfindung die Aufgabe zugrunde, eine Beschichtung sowie ein Herstellungsverfahren für eine derartige Beschichtung zu schaffen, welche die oben genannten Nachteile beseitigten und insbesondere das Reibmoment im gesamten Einsatzbereich reduziert und die Lebensdauer des beschichteten Maschinenteils sowie des Gegenkörpers erhöht.

Erfindungsgemäß wird diese Aufgabe vorrichtungsseitig durch ein Maschinenteil mit einer verschleißfesten Beschichtung mit den Merkmalen des Patentanspruchs 1 und verfahrensseitig durch ein Verfahren mit den Merkmalen des Patentanspruchs 12 gelöst.

Die der vorliegenden Erfindung zugrunde liegende Idee besteht darin, dass die verschleißfeste Beschichtung aus mindestens einer auf eine vorbestimmte Fläche des Maschinenteils aufgebrachten annähernd wasserstofffreien tetraedrischen amorphen Kohlenstoffschicht aus sp²- und sp³-hybridisiertem Kohlenstoff für eine Reibungsreduzierung und für eine Erhöhung des Verschleißwiderstandes der vorbestimmten Fläche des Maschinenteils besteht. Das Schichtsystem besteht dabei beispielsweise aus mehr als 97 Atomprozent Kohlenstoff, wobei der Wasserstoffianteil maximal 3 Atomprozent betragen darf.

Somit weist die vorliegende Erfindung gegenüber den bekannten Ansätzen gemäß dem Stand der Technik den Vorteil auf, dass sich durch die wasserstofffreie Kohlenstoffschicht, insbesondere im ölgeschmierten Zustand, das Reibmoment erheblich reduziert. Ferner wird der Oberflächenzustand erheblich homogenisiert und stabilisiert. Zusätzlich wird der Verschleißwiderstand aufgrund des Anteils an sp³-Bindungen vergrößert. Durch die hervorragenden tribologischen Eigenschaften können kostengünstigere und auch Schmierstoffe mit einer niedrigeren Viskosität verwendet werden, welche geringere innere Reibungen aufweisen. Zudem können Ölwechselintervalle erhöht und somit kundenfreundlicher ausgestaltet werden. Durch die Möglichkeit als Schmierstoffe auch Hydrauliköl, Dieselkraftstoff, Wasser bis hin zu Benzin zu verwenden, bieten sich ganz neue Einsatzgebiete in der Lebensmittelindustrie, hydraulischen und weiteren mediengeschmierten Anwendungen,

In den Unteransprüchen finden sich vorteilhafte Ausgestaltungen und Verbesserungen der im Anspruch 1 angegebenen verschleißfesten Beschichtung sowie des im Patentanspruch 12 angegebenen Verfahrens.

Erfindungsgemäß weist die tetraedrische amorphe Kohlenstoffschicht Härtewerte von 30 bis 95 GPa, ein E-Modul im Bereich von 300 bis 820 GPa und ein Verhältnis aus Härte zu E-Modul von wenigstens 0,15 auf. Derartige Härtewerte tragen zu einer erhöhten Verschleißfestigkeit bei, welche vorzugsweise während der gesamten Lebensdauer des Motors gewährleistet wird.

Gemäß einer bevorzugten Weiterbildung besteht die Beschichtung aus mindestens 97 Atom-% hybridisiertem Kohlenstoff, wobei der Anteil des sp³-hybridisierten Kohlenstoffs in der tetraedrischen amorphen Kohlenstoffschicht mehr als 50% beträgt. Durch einen derartigen hohen Anteil an sp³-Bindungen werden hohe Härtewerte und sehr niedrige Trockenreibwerte erreicht.

Gemäß einem weiteren bevorzugten Ausführungsbeispiel beträgt der Anteil an Wasserstoff in der tetraedrischen amorphen Kohlenstoffschicht maximal 3 Atom-%. Ein derart niedriger Anteil an Wasserstoff ist vorteilhaft, da der Wasserstoff in unerwünschter Weise neue Bindungen, z.B. mit dem Wasserstoff eines Schmierstoffs, eingehen würde. Derartige Bindungen werden somit reduziert und eine gleich bleibende Schichteigenschaft im Betrieb gewährleistet. Ferner wird durch eine annähernd wasserstofffreie Kohlenstoffschicht die Reibung im ölgeschmierten Zustand unter Beachtung des bekannten Effektes der Homogenisierung und Stabilisierung des Oberflächenzustandes erheblich reduziert.

Vorzugsweise weist die tetraedrische amorphe Kohlenstoffschicht eine thermische Stabilitätstemperatur von bzw. eine Oxidationsbeständigkeit bis etwa 600°C auf. Gegenüber wasserstoffhaltigen Kohlenstoffschichten, welche beispielsweise eine thermische Stabilität bis zu lediglich 350°C aufweisen, wird somit eine erhöhte thermische Stabilität erreicht, wodurch sich ein deutlich größeres Einsatzgebiet ergibt.

Vorteilhaft weist die wasserstofffreie tetraedrische amorphe Kohlenstoffschicht eine Dicke von etwa 0,1 µm bis 4,0 µm, insbesondere 2,0 µm auf. Die entsprechende Dicke der Kohlenstoffschicht ist an die jeweiligen Anforderungen bzw. an die jeweiligen Kundenwünsche anzupassen.

Gemäß einem weiteren bevorzugten Ausführungsbeispiel ist zwischen der vorbestimmten Fläche des Maschinenteils und der tetraedrischen amorphen Kohlenstoffschicht mindestens eine Stützschicht und/oder mindestens eine Haftvermittlungsschicht vorgesehen, welche beispielsweise mittels eines PVD-Verfahrens als metallhaltige, beispielsweise Wolfram umfassende, Kohlenstoffschicht, Carbide und/oder Nitride der Übergangsmetalle aufweisende Schicht, mittels einer Wärmebehandlung als Einsatz gehärtete, carbonitrierte oder nitrocarburierte Schicht, mittels eines thermochemischen Verfahrens als nitrierte oder borierte Schicht und/oder beispielsweise mittels eines galvanischen Verfahrens als Chrom aufweisende Schicht ausgebildet ist. Vorzugsweise weist die mindestens eine Stützschicht und/oder Haftvermittlungsschicht jeweils eine Dicke von 0,1 µm bis 4,0 µm auf, wobei die Dicke wiederum jeweils an die entsprechenden Anforderungen bzw. an die Kundenwünsche anzupassen ist.

Beispielsweise besteht die vorbestimmte Fläche des Maschinenteils aus 16MnCr5, C45, 100Cr6, 31CrMoV9, 80Cr2, oder dergleichen.

Vorteilhafte Verwendungen der erfindungsgemäßen Beschichtungen stellen eine Gegenläuferschicht auf einem als Tassenstößel, Schlepp- oder Kipphebel ausgebildeten Gegenläufer bei Verbrennungskraftmaschinen, die Nockenkontaktfläche oder die Nockenkontaktfläche und/oder das Tassenhemd des Tassenstößels, vorbestimmte Oberflächen von Ventiltriebkomponenten, insbesondere von mechanischen und hydraulischen Tassenstößeln, von hydraulischen Abstütz- und Einsteckelementen, von Wälzlagerkomponenten, von Steuerkolben, von Ausrücklagern, von Kolbenbolzen, von Lagerbuchsen, von Linearführungen oder dergleichen dar. Dabei können vorteilhaft lediglich bestimmte Flächen der einzelnen Maschinenteile oder die vollständigen Oberflächen der Maschinenteile mit einer erfindungsgemäßen Beschichtung ausgebildet werden.

Die einzelnen Schichten werden vorzugsweise mittels eines PVD-Verfahrens abgeschieden. Dabei erfolgt vorzugsweise keine thermische und/oder mechanische Nachbearbeitung der abgeschiedenen Kohlenstoffschicht, wenn vorzugsweise eine Reibungsreduzierung gewünscht wird. Eine mechanische Nachbearbeitung, beispielsweise Polieren und/oder Bürsten der abgeschiedenen Kohlenstoffschicht, wird vorzugsweise dann durchgeführt, wenn vorzugsweise Schutz vor einem reibenden Verschleiß gewünscht wird. Der Beschichtungsvorgang wird vorzugsweise bei einer Temperatur durchgeführt, welche maximal 160°C, insbesondere 120°C, beträgt.

Die Erfindung wird im folgenden anhand von Ausführungsbeispielen unter Bezugnahme auf die beiliegenden Figuren der Zeichnung näher erläutert. Von den Figuren zeigen:

### Kurze Beschreibung der Zeichnungen

- Figur 1: eine Vorderansicht einer Reibpaarung, bestehend aus Tassenstößel und Nockenwelle für den Betrieb eines Ventils einer Brennkraftmaschine;
- Figur 2: eine perspektivische Ansicht des Tassenstößels aus Figur 1;
- Figur 3: eine perspektivische Ansicht eines hydraulischen Abstützelementes, welches über eine Wälzlagerkomponente mit einem Schlepphebel in Verbindung steht; und
- Figur 4: eine schematische Querschnittsansicht eines Maschinenteils mit verschleißfester Beschichtung gemäß einem Ausführungsbeispiel der vorliegenden Erfindung.

### Ausführliche Beschreibung der Zeichnungen

In den Figuren der Zeichnung bezeichnen gleiche Bezugszeichen gleiche oder funktionsgleiche Komponenten, soweit nichts Gegenteiliges angegeben ist.

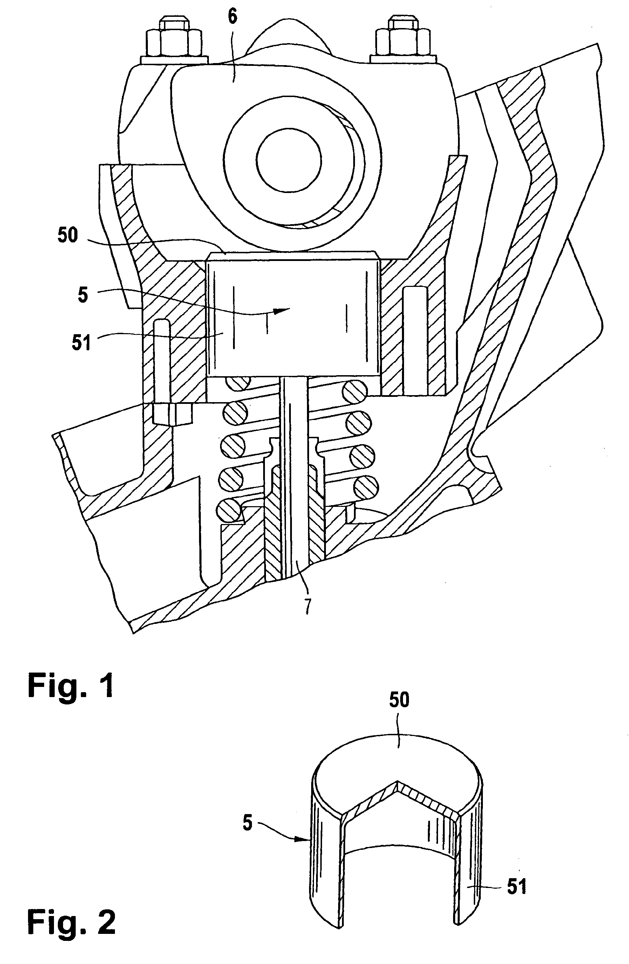

Fig. 1 illustriert eine Reibpaarung, bestehend aus einem Tassenstößel 5 mit einer Nockenkontaktfläche 50 und einem Tassenhemd 51 sowie aus einer Nocke 6. Der Tassenstößel 5 ist in Fig. 2 in einer perspektivischen Ansicht detaillierter dargestellt, wobei ersichtlich ist, dass das Tassenhemd 51 die Nockenkontaktfläche 50 zumindest teilweise umläuft. Der Tassenstößel 5 ist im allgemeinen für Maschinenteile in Brennkraftmaschinen mit dem Schaft 7 eines Ventils verbunden, welches durch Anlage der Nockenfläche mit der Nockenkontaktfläche 50 des Tassenstößels 5 das Ventil öffnet oder schließt.

Im allgemeinen unterliegen moderne Ventiltriebkomponenten, wie beispielsweise Tassen- und Pumpenstößel, hohen Anforderungen bezüglich des Verschleißwiderstandes und der Ressourcenschonung, insbesondere an der Kontaktfläche 50.

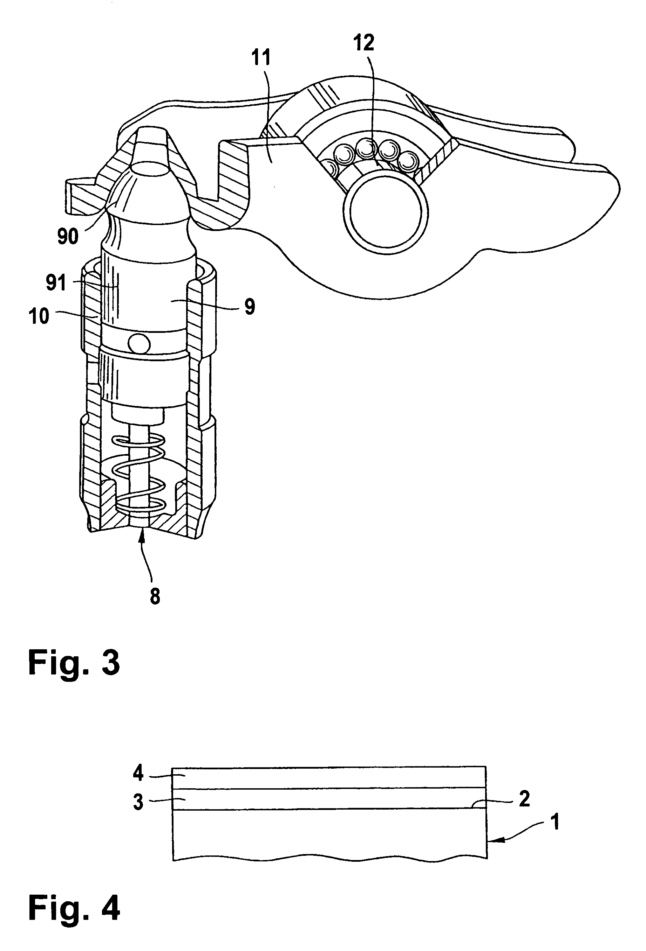

In Verbindung mit Fig. 4, welche eine schematische Querschnittsansicht einer verschleißfesten Beschichtung für ein Maschinenteil 1, beispielsweise für einen Tassenstößel 5, gemäß einem bevorzugten Ausführungsbeispiel der vorliegenden Erfindung illustriert, wird ein Ausführungsbeispiel der vorliegenden Erfindung im folgenden näher erläutert.

Der Tassenstößel 5 wird für eine Reduzierung des Reibungskoeffizienten und für eine Erhöhung des Verschleißwiderstandes im Bereich der Nockenkontaktfläche 50 oder bei Bedarf im Bereich der Nockenkontaktfläche 50 und des Tassenhemdes 51 mit einer erfindungsgemäßen verschleißfesten Beschichtung beschichtet. Im Falle hoher Verformungen des Tassenhemdes 51 des Tassenstößels 50 im Bereich der offenen Seite kann wahlweise auch eine Teilbeschichtung des Tassenhemdes 51, eine ausschließliche Beschichtung der Nockenkontaktfläche 50 oder ein nachträgliches zumindest teilweises Entfernen der reibfesten Beschichtung im Bereich des Tassenhemdes 51 des Tassenstößels 5 erfolgen.

Im vorliegenden Fall gilt zunächst die Annahme, dass die Nockenkontaktfläche 50 des Tassenstößels 5 als vorbestimmte Fläche 2 des Maschinenteils angesehen wird. Es ist für einen Fachmann offensichtlich, dass beliebige vorbestimmte Flächen beliebiger Maschinenteile mit der erfindungsgemäßen Beschichtung beschichtet werden können.

Die vorbestimmte Fläche 2, d.h. vorliegend die Nockenkontaktfläche 50 des Tassenstößels 5, wird vorzugsweise vor einem Beschichten einsatzgehärtet oder carbonitriert und angelassen.

Der Grundkörper, im vorliegenden Fall die Nockenkontaktfläche 50 des Tassenstößels 5, welcher vorteilhaft aus einem kostengünstigen Stahlwerkstoff, wie beispielsweise 16MnCr5, C45, 100Cr6, 31CrMoV9, 80Cr2, oder dergleichen, besteht, wird gemäß dem vorliegenden Ausführungsbeispiel anschließend mit einer Stützschicht 3 und/oder einer Haftvermittlungsschicht 3 beschichtet. Die Stützschicht 3 bzw. die Haftvermittlungsschicht '3 kann beispielsweise jeweils aus einem metallhaltigen Kohlenstoff, beispielsweise einer Verbindung aus Wolfram und Kohlenstoff, aber auch aus anderen metallischen Stoffen, sowie Boriden, Carbiden und Nitriden der Übergangsmetalle bestehen. Die Stützschicht 3 und/oder die Haftvermittlungsschicht 3 kann beispielsweise durch Wärmebehandlung, beispielsweise Einsatzhärten, Carbonitrieren, Nitrocarburieren, durch ein thermochemisches Verfahren, beispielsweise Nitrieren, Borieren, durch ein galvanisches Verfahren, beispielsweise durch Aufbringen einer chromhaltigen Schicht, oder mittels eines PVD-Verfahrens, beispielsweise Aufbringen von Me-C, Carbiden und Nitriden der Übergangsmetalle, gebildet werden. Bei einem PVD-Verfahren, wie beispielsweise bei der Sputter- oder der ARC-Technologie werden gleichzeitig Metalle verdampft und in die zu bildende Schicht eingebracht. Graphit wird dabei als festes Ausgangsmaterial verdampft und mittels Anreicherung durch Einbringen einer hohen Energie auf die vorbestimmte Fläche 2 des Tassenstößels 5 als teilkristalline Schicht abgeschieden.

Es sei an dieser Stelle darauf hingewiesen, dass lediglich eine Stützschicht 3 oder eine Haftvermittlungsschicht 3, mehrere Stützschichten 3 bzw. mehrere Haftvermittlungsschichten 3 oder eine Kombination dieser beiden Schichten auf dem Grundkörper bzw. der vorbestimmten Fläche 2 des Tassenstößels 5 gebildet werden können. Für den Fall, dass eine Haftverbesserung der noch zu bildenden verschleißfesten Beschichtung bzw. einer Stützschicht auf dem Grundkörper gewünscht ist, wird eine Schicht als Haftvermittlungsschicht 3 mit einer Dicke von beispielsweise 0,1 µm bis 2,0 µm auf dem Grundkörper gebildet. Für den Fall, dass die Schicht jedoch als Stützschicht, d.h. als mechanische Stütze zwischen dem Grundkörper und der noch zu bildenden verschleißfesten Beschichtung dienen soll, sind Dicken von beispielsweise 2,0 µm bis 4,0 µm vorteilhaft. Durch die Stützschicht soll die Ermüdungsfestigkeit erhöht werden, d.h. Risse und Brüche der noch zu bildenden verschleißfesten Beschichtung verhindert werden. Derartige Risse können bei Biegungen und Verformungen des Tassenstößels 5 bei Kontakt mit der Nocke 6 oder aufgrund unterschiedlicher Härtegrade, Elastizitätsmodule, Verformbarkeiten der einzelnen Schichten bzw. des Grundkörpers und der verschleißfesten Beschichtung entstehen. In diesem Fall ist eine Ausbildung der Schicht 3 als Stützschicht 3 entweder alleine oder in Kombination mit einer geeigneten Haftvermittlungsschicht vorzuziehen.

Wie in Fig. 4 dargestellt ist, wird gemäß dem vorliegenden Ausführungsbeispiel nach einem Bilden der Stütz- und/oder der Haftvermittlungsschicht 3 eine vierschleißfeste Beschichtung 4 darauf gebildet. Die verschleißfeste Beschichtung 4 besteht vorzugsweise aus einer wasserstofffreien oder zumindest annähernd wasserstofffreien tetraedrischen amorphen Kohlenstoffschicht (ta-C-Schicht) oder mehreren derartiger Schichten 4. Die amorphe Kohlenstoffschicht 4 besteht vorzugsweise lediglich aus sp²- und sp³-hybridisiertem Kohlenstoff, wobei vorteilhaft mehr sp²-Bindungen als sp²-Bindungen in der amorphen Kohlenstoffschicht 4 vorgesehen sind. Dadurch wird der Härtegrad der Beschichtung 4 für eine Erhöhung des Verschleißwiderstandes vergrößert.

Der Wasserstoffanteil in der Beschichtung 4 beträgt vorzugsweise maximal 3 Atom-%, sodass eine extreme Reinheit gewährleistet wird. Dies ist vorteilhaft, da Wasserstoff in der Beschichtung neue Bindungen mit beispielsweise dem Wasserstoff von Schmierstoffen eingehen würde. Gemäß der vorliegenden Erfindung wird durch den geringen Wasserstoffanteil bzw. durch einen Ausschluss von Wasserstoff in der Beschichtung eine gleich bleibende Schichteigenschaft über die gesamte Lebensdauer des Maschinenteils 1 im Betrieb gewährleistet, was einen Einsatz in Motoren und Maschinen in einer Vielzahl von Einsatzgebieten ermöglicht.

Die Härtewerte der wasserstofffreien tetraedrischen amorphen Kohlenstoffschichten 4 (ta-C Schichten) werden im Vergleich zu allen anderen Hartstoffschichten in einem sehr weiten, der jeweiligen Anwendung angepassten, Spektrum von 30 GPa bis 95 GPa (Martenshärte nach EN ISO 14577-1) eingestellt. Im Vergleich hierzu kann man mit den bisher verwendeten Hartstoffschichten (Me-C:H, a-C:H, Metallnitridhartstoffschichten) nur einen Härtebereich von etwa 20 GPa bis 40 GPa abdecken, so dass folglich die ta-C Schichten deutlich höhere Härtewerte und in Folge dessen auch nur diese Verschleißwiderstände aufweisen, die für höchstbeanspruchte Bauteile ausreichend sind. So erreichen die ta-C Schichten im Kalottenschliffverfahren mit Diamantsuspension (Korngröße 0,25 µm) extrem niedrige Verschleißraten von Vᵣ<0,5 x 10⁻¹⁵ m³ N m⁻¹, was dementsprechend einem extrem hohen Verschleißwiderstand entspricht, denn bei identischen Messparametern und -bedingungen weisen alle bisher verwendeten Schichten (Me-C:H, a-C:H, Metallnitridhartstoffschichten Verschleißraten Vᵣ über 0,6 x 10⁻¹⁵ m³ N m⁻¹ bis zu 50 x 10⁻¹⁵ m³ N m⁻¹ auf. Ein wichtiges Qualitätsmerkmal ist das Verhältnis aus Universalhärte [GPa] zu Elastizitätsmodul [GPa]. Hierbei ist ein möglichst hohes Verhältnis anzustreben, das heisst eine Schicht mit einer hohen Härte und damit mit einem hohen Verschleißwiderstand sowie einem im Verhältnis niedrigen Elastizitätsmodul, um möglichst geringe Kontaktspannungen zu übertragen und geringe belastungsinduzierte Spannungen in das Schichtsystem, Interface und Bauteil einzubringen und somit hohe lokale (Dauer-)festigkeiten zu realisieren.

Die E-Module der wasserstofffreien tetraedrischen amorphen Kohlenstoffschichten liegen im Bereich von 300 GPa bis 820 GPa, Stahl hat ein E-Modul von etwa 210 GPa und a-C:H Schichten weisen E-Module von 250 GPa bis 500 GPa auf. Im Vergleich zu allen anderen bisher verwendeten Schichtsystemen und Oberflächen weisen die wasserstofffreien tetraedrischen amorphen Kohlenstoffschichten damit deutlich höhere Härte-zu-Elastizitätsmodul-Verhältnisse von bis zu 0,20 [GPa/GPa] im Gegensatz zu bestenfalls 0,10 bis 0,15 auf.

Die harten Partikel, die sich vermehrt in den hier beschriebenen Motoranwendungen zwischen den Reibpartnern befinden, induzieren hohe lokale Spannungen in die Oberflächen, was zu lokaler Werkstoffermüdung führt, wenn die induzierten Spannungen über der lokalen Dauerfestigkeit des Schichtsystems liegen. Deshalb sind Schichtsysteme notwendig, die möglichst hohe Dauerfestigkeitswerte bzw. Härtewerte sowie einen möglichst hohen Anteil an elastischer Verformbarkeit haben; d.h., dass bei gleicher Materialverformung durch ein hartes Partikel ein möglichst großer Anteil der Verformung elastisch rückverformt und somit ein möglichst geringer Anteil an plastischer Verformung bzw. Schädigung der Oberfläche zurückbleibt. Zur quantitativen Erfassung dieses Qualitätsmerkmals dient der elastische Anteil η_{IT} nach EN ISO 14577-1 "Instrumentierte Eindringprüfung zur Bestimmung der Härte und anderer Werkstoffparameter". Hier erreichen die wasserstofffreien tetraedrischen amorphen Kohlenstoffschichten herausragende Werte bis 95 % und lassen sich zwischen 75 % und 95 % einstellen. Im Vergleich hierzu erreicht gehärteter Stahl 100Cr6 (60 HRC + 4 HRC) etwa 30 % und bisher verwendete Schichten etwa 60 % bis 80%.

Die tetraedrische amorphe Kohlenstoffschicht 4 wird vorzugsweise mittels eines PVD-Verfahrens auf der Stütz- bzw. Haftvermittlungsschicht 3 abgeschieden. Dabei wird beispielsweise Graphit mit einem hochenergetischen Strahl derart erhitzt, dass ein Ionenstrahl aus Kohlenstoffatomen aus dem Graphit herausgelöst und auf die Oberfläche des Tassenstößels 5 bzw. des Maschinenteils 1 gerichtet werden kann. Dadurch werden sp²-Bindungen und sp³-Bindungen auf der Stütz- bzw. Haftvermittlungsschicht 3 abgeschieden. Abhängig von der Energie der Ionen des aus Kohlenstoffatomen bestehenden lonenstrahls, welche beispielsweise Energien von 60 bis 160 Elektronenvolt aufweisen, kann der jeweilige Anteil von sp²-Bindungen und von sp³-Bindungen gesteuert werden. Eine Erhöhung der Energie der Ionen des aus Kohlenstoffatomen bestehenden lonenstrahls erhöht den Anteil an sp³-Bindungen. Somit ergibt sich eine insgesamt amorphe Beschichtung mit kleinen kristallinen Bereichen, welche einen hohen Verschleißwiderstand und geringe Reibungskoeffizienten aufweist.

Bei der Abscheidung der tetraedrischen amorphen Kohlenstoffschicht 4 wird der zu beschichtende Grundkörper in einer Abscheidungskammer beispielsweise derart rotiert, dass bei jedem Rotationszyklus eine Schichtlage des sp²-und sp³-hybridisierten Kohlenstoffs auf dem Grundkörper bzw. der Stütz- bzw. Haftvermittlungsschicht 3 gebildet wird.

Die Dicke der amorphen Kohlenstoffschicht 4 kann zwischen 0,1 µm und 4,0 µm, insbesondere 2,0 µm, betragen. Wird die amorphe Kohlenstoffschicht 4 auf eine Schicht mit guten Oberflächenqualitäten abgeschieden, so genügt beispielsweise eine Dicke von 0,1 µm bis 2,0 µm, da die Kohlenstoffbeschichtung 4 vornehmlich einer Reduzierung des Reibungskoeffizienten dient. Wird hingegen die Kohlenstoffbeschichtung 4 auf eher rauen Oberflächen abgeschieden, so beträgt die Dicke der Beschichtung 4 vorzugsweise in etwa zwischen 2,0 µm und 4,0 µm, da die Beschichtung 4 hierbei vornehmlich zur Vergrößerung des Verschleißwiderstandes dient. Die Härtewerte der Beschichtung 4 liegen vorzugsweise zwischen 60 und 95 GPa, um im Vergleich zu den bisher verwendeten Hartstoffschichten (a-C:H; Me-C:H; Metallnitridschichten) deutlich höhere Verschließwiderstände bereitzustellen.

Zur Erzielung bester tribomechanischer Eigenschaften, d.h. durch das Beschichten eines Reibpartners, die Reibung des Systems zu minimieren, die statische und zyklische Festigkeit des beschichteten Bauteils zu erhöhen und zusätzlich den unbeschichteten Reibpartner vor Verschleiß zu schützen, ist es notwendig, den Mittenrauwert Rₐ nach dem Beschichten auf maximal 0,035 µm zu begrenzen. Beträgt der Mittenrauwert Rₐ nach dem Beschichten mehr als 0,035 µm, so ist eine anschließende mechanische Nachbearbeitung der Funktionsfläche, d.h. der Oberfläche der wasserstofffreien tetraedrischen amorphen Kohlenstoffschicht, durch beispielsweise Polieren und/oder Bürsten vorzunehmen.

Um eine möglichst geringe Adhäsionsneigung zu dem metallischen Gegenkörper, d.h. im vorliegenden Fall dem Nocken 6, einen hohen abrasiven Verschleißwiderstand, eine hohe chemische Beständigkeit, auch im Kontakt mit Öl, hohe mechanische Festigkeiten und große Härte/E-Modul-Verhältnisse zu erreichen, weist die Kohlenstoffschicht vorteilhaft einen maximalen Wasserstoffanteil von 3 Atom-% auf, wie oben bereits erläutert. Somit wird eine wasserstofffreie oder zumindest nahezu wasserstofffreie tetraedrische amorphe Kohlenstoffschicht abgeschieden, welche gegenüber konventionellen wasserstoffhaltigen Kohlenstoffschichten bezüglich des Verschleißes tribophobe Oberflächen mit polarisierenden, die Schmierung- und Reibungsreduzierung unterstützenden Eigenschaften aufweisen. Dadurch ergibt sich sowohl eine Reibungsreduzierung im trockenen Reibkontakt mit metallischen Werkstoffen als auch im geschmierten Zustand. Als Schmierstoff können für bestimmte Anwendungen Flüssigkeiten mit extrem niedriger Viskosität bis hin zu Wasser oder Benzin verwendet werden.

Im oszillierenden Reibkontakt mit einer Stahlkugel aus 100Cr6 (Verfahrweg 1,0 mm, Schwingfrequenz 25 Hz, Kugeldurchmesser 10 mm, Normalkraft der Kugel auf die beschichtete Oberfläche 20 N) verringert sich die Reibung im trockenen Reibkontakt um mehr als 80 % und mit Motoröl um mehr als 10 %. Diese einzigartigen tribologischen Eigenschaften führen dazu, dass im Ventiltrieb durch das Beschichten der Tassenbodenoberfläche Reibungsreduzierungen je nach Öltemperatur und Relativgeschwindigkeit der Reibpartner von 6 % bis 28 % vorherrschen. Der besondere Unterschied zu den bisher verwendeten Schichtsystemen ist, dass sich auch eine deutliche Reibungsreduzierung im Drehzahlbereich von 2000 Umin⁻¹ bis 7000 Umin⁻¹ ergibt, sodass sich ein bisher nicht zu realisierendes Potenzial der Reibungsreduzierung im Ventiltrieb und damit zur Kraftstoffeinsparung bzw. Resourcenschonung, die aufgrund des extrem hohen Verschleißwiderstandes bevorzugt über die gesamte Motorlebensdauer erhalten bleiben, ergibt.

Darüber hinaus bieten die ta-C-Schichten 4 gegenüber Schichten gemäß dem Stand der Technik eine erhöhte Oxidationsbeständigkeit bis etwa 600°C, einen höheren Korrosionswiderstand, einen geringeren elektrischen Leitwert und eine höhere chemische Stabilität, welche eine gleich bleibende Qualität im Einsatz gewährleistet. Aufgrund des extrem hohen Verschleißwiderstandes sind nur geringe Schichtdicken notwendig, wodurch die Gefahr im Einsatz bei Hertzscher Pressung, dass das Vergleichsspannungsmaximum im Interface liegt, umgangen werden kann. Darüber hinaus sind keinerlei Aufmaße erforderlich und die Abscheidezeiten und somit Abscheidekosten bzw. Beschichtungskosten können erheblich reduziert werden.

Neben dem Verschleißschutz des beschichteten Körpers wird auch der Gegenkörper aufgrund der hervorragenden tribologischen Schichteigenschaften der Kohlenstoffschicht bzw. -schichten 4 geschützt. Durch die Verwendung der Beschichtung kann man kostengünstige Werkstoffe als Unterbau verwenden. Als Gegenkörper sind dann im Sinne des Leichtbaus und der Kosteneinsparung auch Eisen-Kohlenstoff-Legierungen für beispielsweise die Nockenwelle bzw. die Nocke 6 realisierbar. Darüber hinaus sind niedrig viskose und niedrig additivierte Öle einsetzbar, wodurch eine Minimalschmierung oder erhöhte Öl-wechselintervalle realisierbar sind.

Im Folgenden wird eine weitere vorteilhafte Verwendung der erfindungsgemä-ßen Beschichtung näher erläutert. Fig. 3 illustriert eine perspektivische Ansicht eines hydraulischen Abstützelementes 8, welches einen Kolben 9 und ein Gehäuse 10 aufweist. Das hydraulische Abstützelement 8 ist mit einem Schlepphebel 11 gekoppelt, wobei der Schlepphebel 11 über ein Wälzlager 12 schwenkbar gelagert ist. Wie in Fig. 3 ferner ersichtlich ist, weist der Kolben 9 einen Kontaktbereich 90 zwischen dem Kolben 9 und dem Schlepphebel 11 auf. Ferner weist der Kolben 9 einen Kontaktbereich 91 zwischen dem Kolben 9 und dem Gehäuse 10 auf. Für eine Reduzierung des Verschleißes im Kontaktbereich 90 zwischen dem Kolben 9 und dem Schlepphebel 11 wird der Kontaktbereich 90 ebenfalls mit einer erfindungsgemäßen wasserstofffreien bzw. annähernd wasserstofffreien tetraedrischen amorphen Kohlenstoffschicht 4, bestehend aus sp²-Bindungen und sp³-Bindungen unter Zwischenschaltung beispielsweise einer Stütz- und/oder Haftvermittlungsschicht beschichtet. Die reibfeste Beschichtung entspricht dabei der in dem ersten Ausführungsbeispiel gemäß den Fig. 1, 2 erläuterten Beschichtung 3, 4.

Ferner kann ebenfalls der Kontaktbereich 91 zwischen dem Kolben 9 und dem Gehäuse 10 mit einer derartigen Beschichtung 3, 4 je nach Anwendung und Fertigungsgstechnologie beschichtet werden. Dadurch wird die Gesamtlebensdauer des dargestellten tribologischen Systems erhöht, wodurch ein Ausfall der einzelnen Maschinenteile während eines Betriebes reduziert und somit insgesamt Kosten eingespart werden können.

Ferner können bestimmte Wälzlagerkomponenten des Wälzlagers 12, beispielsweise der Wälzkörper, die Innen- und Außenringe des Wälzlagers 12, die Wälzlagerkäfige, die Axialscheiben, oder dergleichen ebenfalls zur Erhöhung des Verschleißwiderstandes und zur Reibungsreduzierung mit einer oben beschriebenen wasserstofffreien bzw. annähernd wasserstofffreien tetraedrischen amorphen Kohlenstoffschicht 4, bestehend aus sp²-Bindungen und sp³-Bindungen unter Zwischenschaltung beispielsweise einer Stütz- und/oder Haftvermittlungsschicht 3 beschichtet werden.

Das oben beschriebene Schichtsystem ist selbstverständlich auch für andere Bau- und Funktionseinheiten, wie beispielsweise Abstütz- und Einsteckelemente, Wälzlagerkomponenten, Ausrücklager, Kolbenbolzen, Lagerbuchsen, Steuerkolben für beispielsweise Einspritzdüsen im Motorenbereich, Linearführungen und andere mechanisch und tribologisch hoch beanspruchte Teile geeignet.

Es sei an dieser Stelle darauf hingewiesen, dass die amorphe Kohlenstoffschicht 4 auch direkt auf dem Grundkörper des zu beschichtenden Maschinenteils abgeschieden werden kann, ohne dass eine Stützschicht 3 bzw. Haftvermittlungsschicht 3 dazwischen aufgebracht ist.

Somit schafft die vorliegende Erfindung eine verschleißfeste Beschichtung sowie ein Verfahren zur Herstellung einer derartigen verschleißfesten Beschichtung, wodurch der Verschleißwiderstand von einem reibenden Verschleiß ausgesetzten Maschinenteilen erhöht und zu hohe Reibmomente zwischen diesen Maschinenteilen und entsprechenden Gegenkörpern verhindert werden. Durch die etwa 0,1 µm bis 4,0 µm dicke Beschichtung 4 bzw. 3, 4 bleiben die Maße und Oberflächenrauhigkeiten nahezu unverändert, wobei dennoch die Oberfläche reaktiv homogenisiert wird. Die tribologischen Eigenschaften der Schicht werden verbessert und die mechanischen Beanspruchungen werden mit dem Grundkörper geteilt, der aufgrund der Aufgabenstellung und der geringen Beschichtungstemperatur, welche kleiner als 160°C ist, auf kostengünstigen Stählen gefertigt werden kann. Dadurch sind gängige und kostengünstige Fertigungstechnologien einsetzbar.

Die vorgeschlagenen wasserstofffreien Kohlenstoffschichten reduzieren die Reibung im ölgeschmierten Zustand unter Beachtung des erkannten Effektes der Homogenisierung des Oberflächenzustandes. Es wurden um etwa 20% geringere Reibmomente mit Stahl oder Gusseisen als Reibpartner im ölgeschmierten Zustand gemessen, wodurch sich ein deutlicher Beitrag zur Leistungssteigerung und Ressourcenschonung ergibt. Durch die hervorragenden tribologischen Eigenschaften können kostengünstigere und auch niedrig viskose Schmierstoffe verwendet werden, welche geringere innere Reibungen aufweisen. Ölwechselintervalle können ferner kundenfreundlich erhöht werden.

Darüber hinaus weist die vorgeschlagene ta-C-Schicht eine deutlich höhere thermische Stabilität von etwa 600°C gegenüber 350°C bei wasserstoffhaltigen Kohlenstoffschichten auf, wodurch sich ein größeres Einsatzgebiet ergibt. Durch die Möglichkeit, als Schmierstoff auch Hydrauliköl, Dieselkraftstoff, Wasser bis hin zu Benzin zu verwenden, bieten sich neue Einsatzgebiete in der Lebensmittelindustrie, in hydraulischen und weiteren mediengeschmierten Anwendungen.

Obwohl die vorliegende Erfindung anhand bevorzugter Ausführungsbeispiele vorstehend beschrieben wurde, ist sie darauf nicht beschränkt, sondern auf vielfältige Weise modifizierbar.

### Bezugszeichen

- 1: Maschinenteil
- 2: vorbestimmte Fläche des Maschinenteils
- 3: Stützschicht/Haftvermittlungsschicht
- 4: tetraedrische amorphe Kohlenstoffschicht
- 5: Tassenstößel
- 6: Nocke
- 7: Ventilschaft
- 8: hydraulisches Abstützelement
- 9: Kolben
- 10: Gehäuse
- 11: Schlepphebel
- 12: Wälzlager
- 50: Nockenkontaktfläche
- 51: Tassenhemd
- 90: Kontaktbereich zwischen Kolben und Schlepphebel
- 91: Kontaktbereich zwischen Kolben und Gehäuse

## Patentansprüche

1. Maschinenteil (1) für eine Verbrennungskraftmaschine,
mit einer verschleißfesten Beschichtung auf vorbestimmten Flächen (2) des einem reibenden Verschleiß ausgesetzten Maschinenteils (1), wobei die Beschichtung aus mindestens einer auf die vorbestimmte Fläche (2) des Maschinenteils (1) aufgebrachten wasserstofffreien oder annähernd wasserstofffreien tetraedrischen amorphen Kohlenstoffschicht (4) aus sp²- und sp³-hybridisiertem Kohlenstoff für eine Reibungsreduzierung und für eine Erhöhung des Verschleißwiderstandes der vorbestimmten Fläche (2) des Maschinenteils (1) besteht, und
wobei die tetraedrische amorphe Kohlenstoffschicht (4) Härtewerte von 30 bis 95 GPa Martenshärte, ein E-Modul im Bereich von 300 GPa bis 820 GPa und ein Verhältnis aus Härte zu E-Modul von wenigstens 0,15 aufweist.

2. Maschinenteil nach Anspruch 1, **dadurch gekennzeichnet, dass** die Beschichtung aus mindestens 97 Atom-% hybridisiertem Kohlenstoff besteht, wobei der Anteil des sp³-hybridisierten Kohlenstoffs in dem hybridisierten Kohlenstoff mindestens 50% beträgt.

3. Maschinenteil nach Anspruch 1 oder 2, **dadurch gekennzeichnet, dass** der Anteil an Wasserstoff in der tetraedrischen amorphen Kohlenstoffschicht (4) maximal 1 Atom-% beträgt.

4. Maschinenteil nach wenigstens einem der vorhergehenden Ansprüche, **dadurch gekennzeichnet, dass** die tetraedrische amorphe Kohlenstoffschicht (4) eine thermische Stabilitätstemperatur von bzw. eine Oxidationsbeständigkeit bis 600°C aufweist.

5. Maschinenteil nach wenigstens einem der vorhergehenden Ansprüche, dadurch gekenntzeichnet, dass die tetraedrische amorphe Kohlenstoffschicht (4) eine Dicke von 0,1 µm bis 4,0 µm, insbesondere 2,0 µm, aufweist.

6. Maschinenteil nach wenigstens einem der vorhergehenden Ansprüche, **dadurch gekennzeichnet, dass** zwischen der vorbestimmten Fläche (2) des Maschinenteils (1) und der tetraedrischen amorphen Kohlenstoffschicht (4) mindestens eine Stützschicht (3) und/oder mindestens eine Haftvermittlungsschicht (3) vorgesehen ist, welche beispielsweise mittels eines PVD-Verfahrens als metallhaltige, beispielsweise Wolfram umfassende, Kohlenstoffschicht, als Carbide und/oder Nitride der Übergangsmetalle aufweisende Schicht, als mittels einer Wärmebehandlung einsatzgehärtete, carbonitrierte oder nitrocarburierte Schicht, mittels eines thermochemischen Verfahrens als nitrierte oder borierte Schicht, mittels eines galvanischen Verfahrens als Chrom aufweisende Schicht, beispielsweise als Chromnitridschicht, oder dergleichen ausgebildet ist.

7. Maschinenteil nach Anspruch 6, **dadurch gekennzeichnet, dass** die mindestens eine Stützschicht (3) und/oder die mindestens eine Haftvermittlungsschicht (3) eine Dicke von 0,1 µm bis 4,0 µm aufweist.

8. Maschinenteil nach wenigstens einem der vorhergehenden Ansprüche, **dadurch gekennzeichnet, dass** die vorbestimmte Fläche (2) des Maschinenteils (1) aus 16MnCr5, C45, 100Cr6, 31CrMoV9, 80Cr2, etc. besteht.

9. Maschinenteil nach wenigstens einem der vorhergehenden Ansprüche, **dadurch gekennzeichnet, dass** die Beschichtung (3, 4) als Gegenläuferschicht auf dem als Tassenstößels (5), Schlepp- oder Kipphebel (11) ausgebildeten Maschinenteil verwendet wird.

10. Maschinenteil nach Anspruch 9, **dadurch gekennzeichnet, dass** die Nockenkontaktfläche (50) des Tassenstößels (5), oder die Nockenkontaktfläche (50) und das Tassenhemd (51) des Tassenstößels (5) vollständig oder zumindest teilweise mit der verschleißfesten Beschichtung ausgebildet ist.

11. Maschinenteil nach wenigstens einem der Ansprüche 1 bis 8, **dadurch gekennzeichnet, dass** die Beschichtung (3, 4) als Schicht auf vorbestimmten Flächen von Ventiltriebkomponenten, mechanischen und hydraulischen Tassenstößeln, hydraulischen Abstütz- und Einsteckelementen, Wälzlagerkomponenten, Steuerkolben, insbesondere für Einspritzdüsen im Motorenbereich, von Ausrücklagern, von Kolbenbolzen, von Lagerbuchsen, von LinearFührungen, oder dergleichen verwendet wird.

12. Verfahren zur Herstellung einer verschleißfesten Beschichtung auf vorbestimmten Flächen (2) von einem reibenden Verschleiß ausgesetzten Maschinenteilen (1) für eine Verbrennungskraftmaschine, mit folgendem Verfahrensschritt:
Abscheiden mindestens einer wasserstofffreien oder annähernd wasserstofffreien tetraedrischen amorphen Kohlenstoffschicht (4) aus sp²- und sp³-hybridisiertem Kohlenstoff auf der vorbestimmten Fläche (2) des Maschinenteils (1) für eine Reibungsreduzierung und für eine Erhöhung des Verschleißwiderstandes der vorbestimmten Fläche (2),
wobei die tetraedrische amorphe Kohlenstoffschicht (4) derart ausgebildet wird, dass sie Härtewerte von 30 bis 95 GPa Martenshärte, ein E-Modul im Bereich von 300 GPa bis 820 GPa und ein Verhältnis aus Härte zu E-Modul von wenigstens 0,15 aufweist.

13. Verfahren nach Anspruch 12, **dadurch gekennzeichnet, dass** die Abscheidung mittels eines PVD-Verfahrens bewerkstelligt wird.

14. Verfahren nach Anspruch 12 oder 13, **dadurch gekennzeichnet, dass** die tetraedrische amorphe Kohlenstoffschicht (4) mit einer Dicke von 0,1 µm bis 4,0 µm, insbesondere 2,0 µm, ausgebildet wird.

15. Verfahren nach wenigstens einem der Ansprüche 12 bis 14, **dadurch gekennzeichnet, dass** der Beschichtungsvorgang bei einer Temperatur durchgeführt wird, welche maximal 160°C, insbesondere 120°C, beträgt.

16. Verfahren nach wenigstens einem der Ansprüche 12 bis 15, **dadurch gekennzeichnet, dass** keine thermische und/oder mechanische Nachbearbeitung der abgeschiedenen amorphen Kohlenstoffschicht (4) durchgeführt wird, wenn vorzugsweise eine Reibungsreduzierung gewünscht wird.

17. Verfahren nach wenigstens einem der Ansprüche 12 bis 15, **dadurch gekennzeichnet, dass** eine mechanische Nachbearbeitung, beispielsweise ein Polieren und/oder Bürsten, der abgeschiedenen amorphen Kohlenstoffschicht (4) durchgeführt wird, wenn vorzugsweise ein Schutz vor einem reibenden Verschleiß gewünscht wird.

18. Verfahren nach wenigstens einem der Ansprüche 12 bis 17, **dadurch gekennzeichnet, dass** die vorbestimmte Fläche (2) des Maschinenteils (1) aus 16MnCr5, C45, 100Cr6, 31 CrMoV9, 80Cr2, oder dergleichen hergestellt wird.

19. Verfahren nach wenigstens einem der Ansprüche 12 bis 18, **dadurch gekennzeichnet, dass** vor der Abscheidung die vorbestimmte Fläche (2) des Maschinenteils (1) einsatzgehärtet und/oder carbonitriert und angelassen wird.

20. Verfahren nach wenigstens einem der Ansprüche 12 bis 19, **dadurch gekennzeichnet, dass** zwischen der vorbestimmten Fläche (2) des Maschinenteils (1) und der tetraedrischen amorphen Kohlenstoffschicht (4) mindestens eine Stützschicht (3) und/oder mindestens eine Haftvermittlungsschicht (3) vorgesehen ist, welche beispielsweise mittels eines PVD-Verfahrens als metallhaltige, beispielsweise Wolfram umfassende, Kohlenstoffschicht, als Carbide und/oder Nitride der Übergangsmetalle aufweisende Schicht, mittels einer Wärmebehandlung als einsatzgehärtete, carbonitrierte oder nitrocarburierte Schicht, mittels eines thermochemischen Verfahrens als nitrierte oder borierte Schicht, mittels eines galvanischen Verfahrens als Chrom aufweisende Schicht, beispielsweise als Chromnitridschicht, oder dergleichen ausgebildet wird.

21. Verfahren nach Anspruch 20, **dadurch gekennzeichnet, dass** die mindestens eine Stützschicht (3) und/oder die mindestens eine Haftvermittlungsschicht (3) mit einer Dicke von 0,1 µm bis 4,0 µm ausgebildet wird.

22. Verfahren nach wenigstens einem der Ansprüche 12 bis 21, **dadurch gekennzeichnet, dass** die Beschichtung aus mindestens 97 Atom-% hybridisiertem Kohlenstoff ausgebildet wird, wobei der Anteil des sp³-hybridisierten Kohlenstoffs in dem hybridisierten Kohlenstoff mindestens 50% beträgt.

## Claims

1. Engine part (1) for an internal combustion engine, having a wear-resistant coating on predetermined surfaces (2) of the engine part (1) exposed to frictional wear,
wherein the coating consists of at least one hydrogen-free or approximately hydrogen-free tetrahedral amorphous carbon layer (4) of sp²-hybridized and sp³-hybridized carbon, which is applied to the predetermined surface (2) of the engine part (1), for friction reduction and for increasing the wear resistance of the predetermined surface (2) of the engine part (1),
and
wherein the tetrahedral amorphous carbon layer (4) has hardness values of 30 to 95 GPa Martens hardness, a modulus of elasticity in the range of 300 GPa to 820 GPa and a ratio of hardness to modulus of elasticity of at least 0.15.

2. Engine part according to Claim 1, **characterized in that** the coating consists of at least 97 atom% hybridized carbon, the proportion of the sp³-hybridized carbon in the hybridized carbon being at least 50%.

3. Engine part according to Claim 1 or 2, **characterized in that** the proportion of hydrogen in the tetrahedral amorphous carbon layer (4) is at most 1 atom%.

4. Engine part according to at least one of the preceding claims, **characterized in that** the tetrahedral amorphous carbon layer (4) has a thermal stability temperature of, or an oxidation resistance up to, 600°C.

5. Engine part according to at least one of the preceding claims, **characterized in that** the tetrahedral amorphous carbon layer (4) has a thickness of 0.1 µm to 4.0 µm, in particular of 2.0 µm.

6. Engine part according to at least one of the preceding claims, **characterized in that** at least one supporting layer (3) and/or at least one bonding layer (3) is provided between the predetermined surface (2) of the engine part (1) and the tetrahedral amorphous carbon layer (4), and is formed, for example, by means of a PVD process as a metal-containing, for example tungsten-comprising, carbon layer, as a layer which includes carbides and/or nitrides of the transition metals, as a layer which has been nitrocarburized, carbonitrided or case-hardened by means of a heat treatment, as a layer which has been nitrided or borided by means of a thermochemical process, as a layer which includes chromium formed by means of an electroplating process, for example as a chromium nitride layer, or the like.

7. Engine part according to Claim 6, **characterized in that** the at least one supporting layer (3) and/or the at least one bonding layer (3) has a thickness of 0.1 µm to 4.0 µm.

8. Engine part according to at least one of the preceding claims, **characterized in that** the predetermined surface (2) of the engine part (1) consists of 16MnCr5, C45, 100Cr6, 31CrMoV9, 80Cr2, etc.

9. Engine part according to at least one of the preceding claims, **characterized in that** the coating (3, 4) is used as an opposing running layer on the engine part formed as a bucket tappet (5) or a drag or rocker lever (11).

10. Engine part according to Claim 9, **characterized in that** the cam contact surface (50) of the bucket tappet (5), or the cam contact surface (50) and the bucket skirt (51) of the bucket tappet (5), is/are formed completely or at least partially with the wear-resistant coating.

11. Engine part according to at least one of Claims 1 to 8, **characterized in that** the coating (3, 4) is used as a layer on predetermined surfaces of valve gear components, mechanical and hydraulic bucket tappets, hydraulic supporting and insertion elements, rolling bearing components, control pistons, in particular for injection nozzles used in engines, of release bearings, of piston pins, of bearing bushes, of linear guides, or the like.

12. Process for producing a wear-resistant coating on predetermined surfaces (2) of engine parts (1), exposed to frictional wear, for an internal combustion engine, comprising the following process step:
depositing at least one hydrogen-free or approximately hydrogen-free tetrahedral amorphous carbon layer (4) of sp²-hybridized and sp³-hybridized carbon on the predetermined surface (2) of the engine part (1), for friction reduction and for increasing the wear resistance of the predetermined surface (2),
wherein the tetrahedral amorphous carbon layer (4) is formed in such a manner that it has hardness values of 30 to 95 GPa Martens hardness, a modulus of elasticity in the range of 300 GPa to 820 GPa and a ratio of hardness to modulus of elasticity of at least 0.15.

13. Process according to Claim 12, **characterized in that** the deposition is carried out by means of a PVD process.

14. Process according to Claim 12 or 13, **characterized in that** the tetrahedral amorphous carbon layer (4) is formed with a thickness of 0.1 µm to 4.0 µm, in particular of 2.0 µm.

15. Process according to at least one of Claims 12 to 14, **characterized in that** the coating operation is carried out at a temperature of at most 160°C, in particular 120°C.

16. Process according to at least one of Claims 12 to 15, **characterized in that** the amorphous carbon layer (4) which has been deposited is not subjected to any thermal and/or mechanical subsequent machining, if preferably a reduction in friction is desired.

17. Process according to at least one of Claims 12 to 15, **characterized in that** the amorphous carbon layer (4) which has been deposited is subjected to mechanical subsequent machining, for example polishing and/or brushing, if preferably protection against frictional wear is desired.

18. Process according to at least one of Claims 12 to 17, **characterized in that** the predetermined surface (2) of the engine part (1) is produced from 16MnCr5, C45, 100Cr6, 31CrMoV9, 80Cr2, or the like.

19. Process according to at least one of Claims 12 to 18, **characterized in that** the predetermined surface (2) of the engine part (1) is case-hardened and/or carbonitrided and tempered before the deposition.

20. Process according to at least one of Claims 12 to 19, **characterized in that** at least one supporting layer (3) and/or at least one bonding layer (3) is provided between the predetermined surface (2) of the engine part (1) and the tetrahedral amorphous carbon layer (4), and is formed, for example, by means of a PVD process as a metal-containing, for example tungsten-comprising, carbon layer, as a layer which includes carbides and/or nitrides of the transition metals, as a layer which has been nitrocarburized, carbonitrided or case-hardened by means of a heat treatment, as a layer which has been nitrided or borided by means of a thermochemical process, as a layer which includes chromium formed by means of an electroplating process, for example as a chromium nitride layer, or the like.

21. Process according to Claim 20, **characterized in that** the at least one supporting layer (3) and/or the at least one bonding layer (3) is formed with a thickness of 0.1 µm to 4.0 µm.

22. Process according to at least one of Claims 12 to 21, **characterized in that** the coating is formed from at least 97 atom% hybridized carbon, the proportion of the sp³-hybridized carbon in the hybridized carbon being at least 50%.

## Revendications

1. Pièce de machine (1) pour un moteur à combustion interne, présentant un revêtement résistant à l'usure sur des surfaces (2) prédéterminées de la pièce de machine (1) exposée à une usure par frottement, le revêtement étant constitué par au moins une couche de carbone (4), appliquée sur la surface (2) prédéterminée de la pièce de machine (1), de carbone exempte d'hydrogène ou quasiment exempte d'hydrogène, tétraédrique amorphe en carbone hybridé en sp² et sp³, pour une réduction du frottement et pour une augmentation de la résistance à l'usure de la surface (2) prédéterminée de la pièce de machine (1) et la couche de carbone (4) tétraédrique amorphe présentant des valeurs de dureté de 30 à 95 GPa de dureté Martens, un module E dans la plage de 300 GPa à 820 GPa et un rapport de la dureté au module E d'au moins 0,15.

2. Pièce de machine selon la revendication 1, **caractérisée en ce que** le revêtement est constitué par au moins 97% en atome de carbone hybride, la proportion de carbone hybridé en sp³ dans le carbone hybridé représentant au moins 50%.

3. Pièce de machine selon la revendication 1 ou 2, **caractérisée en ce que** la proportion d'hydrogène dans la couche de carbone (4) tétraédrique amorphe est d'au maximum 1% en atome.

4. Pièce de machine selon au moins l'une quelconque des revendications précédentes, **caractérisée en ce que** la couche de carbone (4) tétraédrique amorphe présente une température de stabilité thermique de ou une résistance à l'oxydation jusqu'à environ 600°C.

5. Pièce de machine selon au moins l'une quelconque des revendications précédentes, **caractérisée en ce que** la couche de carbone (4) tétraédrique amorphe présente une épaisseur de 0,1 à 4,0 µm, en particulier de 2,0 µm.

6. Pièce de machine selon au moins l'une quelconque des revendications précédentes, **caractérisée en ce qu'**on a prévu, entre la surface (2) prédéterminée de la pièce de machine (1) et la couche de carbone (4) tétraédrique amorphe, au moins une couche support (3) et/ou au moins une couche de promoteur d'adhérence (3) qui est par exemple réalisée au moyen d'un procédé de dépôt physique en phase vapeur (PVD) sous forme de couche de carbone contenant un métal, par exemple du tungstène, sous forme de couche présentant des carbures et/ou des nitrures des métaux de transition, sous forme de couche cémentée au moyen d'un traitement thermique, carbonitrurée ou nitrocarburée, sous forme d'une couche nitrurée ou borée au moyen d'un procédé thermochimique, sous forme d'une couche présentant du chrome au moyen d'un procédé galvanique, par exemple sous forme de couche de nitrure de chrome, ou analogue.

7. Pièce de machine selon la revendication 6, **caractérisée en ce qu'**elle présente au moins une couche support (3) et/ou au moins une couche de promoteur d'adhérence (3) d'une épaisseur de 0,1 µm à 4,0 µm.

8. Pièce de machine selon au moins l'une quelconque des revendications précédentes, **caractérisée en ce que** la surface (2) prédéterminée de la pièce de machine (1) est constituée de 16MnCr5, de C45, de 100Cr6, de 31CrMoV9, de 80Cr2, etc.

9. Pièce de machine selon au moins l'une quelconque des revendications précédentes, **caractérisée en ce que** le revêtement (3, 4) est utilisé comme couche de roulement opposée sur laquelle la pièce de machine réalisée sous forme de poussoir creux (5), de levier de traction ou de culbuteur (11) est utilisée.

10. Pièce de machine selon la revendication 9, **caractérisée en ce que** la surface de contact (50) avec la came du poussoir creux (5), ou la surface de contact (50) de came et la chemise (51) du poussoir creux (5) est réalisée complètement ou du moins en partie avec le revêtement résistant à l'usure.

11. Pièce de machine selon au moins l'une quelconque des revendications 1 à 8, **caractérisée en ce que** le revêtement (3, 4) est utilisé comme couche sur des surfaces prédéterminées de composants de commande de soupapes, de poussoirs creux mécaniques et hydrauliques, d'éléments support et emboîtés hydrauliques, de composants de paliers à roulement, de pistons de commande, en particulier pour des gicleurs d'injection dans le domaine des moteurs, de butées d'embrayage, d'axes de piston, de bagues de palier, de commandes linéaires ou analogues.

12. Procédé pour la réalisation d'un revêtement résistant à l'usure sur des surfaces (2) prédéterminées de pièces de machine (1) soumises à une usure par frottement pour un moteur à combustion interne, présentant l'étape de procédé suivante :
dépôt d'au moins une couche de carbone (4) tétraédrique amorphe, exempte d'hydrogène ou quasiment exempte d'hydrogène, en carbone hybridé en sp² et sp³ sur la surface (2) prédéterminée de la pièce de machine (1) pour une réduction du frottement et pour une augmentation de la résistance à l'usure de la surface (2) prédéterminée,
la couche de carbone (4) tétraédrique amorphe étant réalisée de manière telle qu'elle présente des valeurs de dureté de 30 à 95 GPa de dureté de Martens, un module E dans la plage de 300 GPa à 820 GPa et un rapport de la dureté au module E d'au moins 0,15.

13. Procédé selon la revendication 12, **caractérisé en ce que** le dépôt est réalisé au moyen d'un procédé de dépôt physique en phase vapeur (PVD).

14. Procédé selon la revendication 12 ou 13, **caractérisé en ce que** la couche de carbone (4) tétraédrique amorphe est réalisée à une épaisseur de 0,1 à 4,0 µm, en particulier de 2,0 µm.

15. Procédé selon au moins l'une quelconque des revendications 12 à 14, **caractérisé en ce que** le processus de revêtement est réalisé à une température qui est d'au maximum 160°C, en particulier 120°C.

16. Procédé selon au moins l'une quelconque des revendications 12 à 15, **caractérisé en ce qu'**aucun traitement ultérieur thermique et/ou mécanique de la couche de carbone (4) amorphe déposée n'est réalisé lorsqu'on souhaite de préférence une réduction du frottement.

17. Procédé selon au moins l'une quelconque des revendications 12 à 15, **caractérisé en ce qu'**un traitement ultérieur mécanique, par exemple un polissage et/ou un brossage, de la couche de carbone (4) amorphe déposée est réalisé lorsqu'on souhaite de préférence une protection contre une usure par frottement.

18. Procédé selon au moins l'une quelconque des revendications 12 à 17, **caractérisé en ce que** la surface (2) prédéterminée de la pièce de machine (1) est réalisée en 16MnCr5, C45, 100Cr6, 31CrMoV9, 80Cr2 ou analogue.

19. Procédé selon au moins l'une quelconque des revendications 12 à 18, **caractérisé en ce que** la surface (2) prédéterminée de la pièce de machine (1) est cémentée et/ou carbonitrurée et recuite.

20. Procédé selon au moins l'une quelconque des revendications 12 à 19, **caractérisé en ce qu'**on a prévu, entre la surface (2) prédéterminée de la pièce de machine (1) et la couche de carbone (4) tétraédrique amorphe, au moins une couche support (3) et/ou au moins une couche de promoteur d'adhérence (3) qui est par exemple réalisée au moyen d'un procédé de dépôt physique en phase vapeur (PVD) sous forme de couche de carbone contenant un métal, par exemple du tungstène, sous forme de couche présentant des carbures et/ou des nitrures des métaux de transition, sous forme de couche cémentée au moyen d'un traitement thermique, carbonitrurée ou nitrocarburée, sous forme d'une couche nitrurée ou borée au moyen d'un procédé thermochimique, sous forme d'une couche présentant du chrome au moyen d'un procédé galvanique, par exemple sous forme de couche de nitrure de chrome, ou analogue.

21. Procédé selon la revendication 20, **caractérisé en ce que** ladite au moins une couche support (3) et/ou ladite au moins une couche de promoteur d'adhérence (3) est réalisée à une épaisseur de 0,1 µm à 4,0 µm.

22. Procédé selon au moins l'une quelconque des revendications 12 à 21, **caractérisé en ce que** le revêtement est constitué par au moins 97% en atome de carbone hybridé, la proportion de carbone hybridé en sp³ dans le carbone hybridé représentant au moins 50%.
